# EUROPÄISCHE PATENTSCHRIFT

(11) **EP 1 819 208 B1**
(45) Veröffentlichungstag und Bekanntmachung des Hinweises auf die Patenterteilung: **14.10.2015**
(21) Anmeldenummer: 07002431.0
(22) Anmeldetag: 05.02.2007
(51) Int. Cl.: H05H 1/46, H01J 37/32

(54) **Vorrichtung und Verfahren zur Erzeugung angeregter und/oder ionisierter Teilchen in einem Plasma**
Device and method for creating activated and/or ionised particles in a plasma
Dispositif et procédé de production de particules excitées et/ou ionisées dans un plasma

(30) Priorität: 10.02.2006 DE 102006006289
(43) Veröffentlichungstag der Anmeldung: 15.08.2007
(73) Patentinhaber: Muegge GmbH, 64385 Reichelsheim (Odenwald) (DE)
(72) Erfinder: Gschwandtner, Alexander, Dr., 80687 München (DE)
(74) Vertreter: Lang, Friedrich

(56) Entgegenhaltungen:
- WO-A-2004/073363
- JP-A- 59 130 428
- US-A- 5 010 276
- US-A- 5 202 095
- US-A- 5 234 526

## Beschreibung

Die Erfindung betrifft eine Vorrichtung zur Erzeugung angeregter und/oder ionisierter Teilchen in einem Plasma aus einem Prozessgas, die einen Generator zur Erzeugung einer elektromagnetischen Welle, einen Hohlleiter und eine Gasentladungskammer mit einem Gasentladungsraum umfasst, wobei in dem Gasentladungsraum die angeregten und/oder ionisierten Teilchen gebildet werden und die Gasentladungskammer ein Dielektrikum umfasst, in dem der Gasentladungsraum ausgebildet ist, wobei die Gasentladungskammer innerhalb des Hohlleiters angeordnet ist. Ferner betrifft die Erfindung ein Verfahren zur Erzeugung angeregter und/oder ionisierter Teilchen in einem Plasma aus einem Prozessgas, bei dem eine elektromagnetische Welle erzeugt und in ein Dielektrikum einer Gasentladungskammer eingekoppelt wird, wobei im Dielektrikum ein Gasentladungsraum ausgebildet ist, der einen Gaseinlass und einen Gasauslass zum Zu- bzw. Abführen von Prozessgas aufweist, und wobei die Gasentladungskammer innerhalb eines Hohlleiters angeordnet ist.

Hochleistungsplasmavorrichtungen sind grundsätzlich aus dem Stand der Technik bekannt. Sie werden beispielsweise als externe Plasmaquellen, als sogenannte "Remote-Plasmaquellen", zum Reinigen von Beschichtungs- und Ätzkammern eingesetzt, wobei das Plasma in einem separaten Raum erzeugt wird, um dann das angeregte Gas durch ein Rohr oder eine andere geeignete Zuführung in eine Reaktionskammer zu leiten. Eine weitere Anwendung der Hochleistungsplasmavorrichtungen besteht beispielsweise darin, dass die Vorrichtungen direkt in die Beschichtungs- oder Ätzkammer integriert werden. Dabei ist im Gegensatz zu den Remote-Plasmaquellen zu beachten, dass das angeregte Gas in der Reaktionskammer über einen gewissen Raumwinkel gleichmäßig verteilt wird, um die gewünschten Ergebnisse zu erzielen.

Hochfrequenzplasmavorrichtungen mit einem hohen Wirkungsgrad sind besonders zur Verwendung für Ätz- und Beschichtungsprozesse für Halbleiterbauelemente und Produkte der Mikromechanik geeignet. Hierfür sind spezielle Plasmavorrichtungen erforderlich, wobei die Prozessgase durch hochfrequente elektromagnetische Wellen auf engstem Raum zerlegt und deren Bruchstücke noch weiter angeregt werden. Durch die Verwendung von Hochleistungsplasmavorrichtungen werden Ätzgase, wie z. B. NF₃, CF₄, C₂F₆, SF₆, O₂, etc., nahezu vollständig in ihre Bestandteile zerlegt und sind dadurch besonders umweltverträglich. Als elektromagnetische Wellen werden in der Regel Mikrowellen verwendet. Durch die Konzentration der Mikrowellenenergie auf engstem Raum sind die Materialien der Gasentladungskammer besonders hohen thermischen Belastungen ausgesetzt, wobei gleichzeitig auch die inneren Oberflächen der Entladungskammer einem chemischen Angriff ausgesetzt sind, der bekanntlich exponentiell mit der Temperatur der Materialien zunimmt.

Eine bekannte Hochleistungsplasmavorrichtung ist beispielsweise in der JP 07029889 A offenbart, bei der die Entladungskammer in einem Teilbereich eines Hohlleiters angeordnet ist, in dessen von der Entladungskammer entferntem Ende eine von einem Mikrowellengenerator erzeugte Mikrowelle eingekoppelt wird (siehe Fig. 4 von JP 07029889 A). Bei einer derartigen Vorrichtung ist eine effektive Kühlung der Plasmazone bzw. der Entladungskammer nicht möglich, da die Mikrowelle im Bereich des Hohlleiters in die Entladungskammer eindringen muss, was z. B. durch eine Ummantelung der Entladungskammer mittels einer Wasserkühlvorrichtung unterbunden würde. Auch bei Hochleistungsplasmavorrichtungen gemäß den Fig. 1 und 3 von JP 07029889 A, bei denen die Mikrowelle mittels eines Koaxialleitersystems in die Entladungskammer eingebracht wird, wobei sich der Innenleiter fast über die gesamte Länge der Gasentladungskammer erstreckt, ist eine vollständige Ummantelung der Entladungskammer mit einer Wasserkühlung ebenfalls nicht möglich. Dadurch sind teilweise hohe thermische Belastungen der Entladungskammern unvermeidlich. Infolge der ungleichmäßigen thermischen Belastungen kommt es zu großen mechanischen Verspannungen der Entladungskammern, die in der Regel aus spröder Keramik oder Glas bestehen. Bei größeren Mikrowellenleistungen kommt es zu Rissen in den Entladungskammern, so dass die oben beschriebenen Vorrichtungen nur bei stark eingeschränkter Leistung verwendet werden können. Außerdem ist der zu erwartende chemische Angriff an den stark erhitzten Teilen der Entladungskammern erheblich.

Eine andere bekannte Plasmavorrichtung ist in der WO 2004/073363 A1 (US 2006/0137613 A1) offenbart.

Daher ist es **Aufgabe** der vorliegenden Erfindung eine Vorrichtung sowie ein Verfahren zur Erzeugung angeregter und/oder ionisierter Teilchen in einem Plasma anzugeben, die mit großen Mikrowellenleistungen verwendet werden können und bei denen gleichzeitig die Gasentladungskammer eine lange Standzeit aufweist. Die Lösung dieser Aufgabe gelingt mit einer Vorrichtung gemäß dem Oberbegriff des Anspruchs 1, bei der das Dielektrikum eine stirnseitige Basis ausbildet, von der sich unter Bildung des Gasentladungsraums Seitenwände, die ebenfalls aus Dielektrikum bestehen, erstrecken. Ferner ist die Vorrichtung derart ausgebildet, dass elektromagnetische Wellen in die stirnseitige Basis einkoppelbar sind.

Die erfindungsgemäße Vorrichtung umfasst also eine Gasentladungskammer, die wiederum aus einem Dielektrikum, beispielsweise einer Keramik, und einem im Dielektrikum ausgebildeten Hohlraum, dem Gasentladungsraum, besteht. Im Gasentladungsraum wird das Plasma erzeugt. Die Gasentladungskammer der vorliegenden Erfindung ist nun derart ausgestaltet, dass das Dielektrikum eine stirnseitige Basis ausbildet. Dies bedeutet, dass das Dielektrikum an einer Stirnseite der Gasentladungskammer eine Basis oder auch einen Boden ausbildet. Die Basis kann grundsätzlich jede beliebige bzw. zweckmäßige Form aufweisen und besteht aus Dielektrikum. Von dieser Basis gehen nun Seitenwände ab, die ebenfalls aus Dielektrikum bestehen. Die Basis und die Seitenwände bilden zusammen einen Hohlraum aus, der als Gasentladungsraum dient. Daher sind die Seitenwände also zweckmäßigerweise umlaufend ausgebildet. Ferner werden nun bei der vorliegenden Erfindung die elektromagnetischen Wellen, die vom Generator erzeugt werden, in die stirnseitige Basis der Gasentladungskammer eingekoppelt. Im Gegensatz zum Stand der Technik wird bei der vorliegenden Erfindung die elektromagnetische Welle also nur punktuell und lokal begrenzt in die Gasentladungskammer eingekoppelt bzw. eingeleitet. Von der stirnseitigen Basis breitet sich die elektromagnetische Welle dann weiter durch den Rest der Gasentladungskammer, das heißt die Seitenwände aus Dielektrikum und den Gasentladungsraum, in dem sich die erforderlichen Gase befinden, die durch die Mikrowelle angeregt werden, aus.

Durch die spezielle Ausbildung der vorliegenden Erfindung, und insbesondere die nur punktuelle Einkopplung der elektromagnetischen Wellen in die Gasentladungskammer, ist es möglich, dass die Gasentladungskammer eine im Wesentlichen ganzflächige Kühlung aufweist, um die in dem Entladungsraum entstehende Wärme möglichst gleichmäßig an die Kühlflüssigkeit, beispielsweise Wasser, abzuführen. Dadurch wird sichergestellt, dass der in der Plasmazone erzeugte, gleichmäßige Wärmeeintrag auch gleichmäßig über die Kühlung abgeführt werden kann und somit die mechanischen Verspannungen im Dielektrikum, beispielsweise ein Keramik- oder Glaskörper, minimiert werden. Außerdem wird durch eine ganzflächige Kühlung die Temperatur der Entladungskammer möglichst niedrig gehalten, so dass der chemische Angriff auf das Kammermaterial minimiert wird. Ein weiterer Vorteil der Erfindung ist, dass der Entladungsraum der Anregungs- bzw. Entladungskammer derart ausgestaltet werden kann, dass eine gleichmäßige thermische Belastung der Entladungskammer erzielt wird, wodurch die mechanischen Verspannungen minimiert werden. Insgesamt wird mit der vorliegenden Erfindung also die Produktivität von Hochleistungsplasmavorrichtungen, insbesondere von solchen die in Halbleiterproduktionsanlagen verwendet werden, gesteigert und die Umweltverträglichkeit der Prozesse wird verbessert.

Bei der erfindungsgemäßen Vorrichtung wird die elektromagnetische Welle, insbesondere eine Mikrowelle mit den gebräuchlichen und von Amts wegen zugelassenen Frequenzen von 915 MHz, 2,45 GHz oder 5,8 GHz, vorteilhafterweise mittels eines Koppelstiftes, der Teil einer Koaxialleitung ist, durch die die Welle vom Mikrowellengenerator zur Gasentladungskammer geführt wird, in die Gasentladungskammer eingekoppelt. Grundsätzlich ist die Einkopplung bzw. Auskopplung von Mikrowellenenergie von einem Koaxialsystem in ein Hohlleitersystem mittels eines Koppelstifts allgemein bekannt. Bei der erfindungsgemäßen Vorrichtung wird die Anordnung der Koppelstifte derart ausgewählt, dass die gesamte Mikrowellenenergie in die Gasentladungskammer eingekoppelt werden kann, ohne dass ein Teil der Energie reflektiert wird. Dabei ist zu beachten, dass die Ausbreitungsgeschwindigkeit der Welle im Dielektrikum mit ε^{-½} (Wurzel aus relativer Dielektrizitätskonstante) abnimmt und dadurch die Dimensionen der Koppelstifte und deren Abstand zu den Reflektionsebenen entsprechend angepasst werden müssen. Wird beispielsweise Aluminiumoxid mit einer relativen Elektrizitätskonstante von ca. 9 als Dielektrikum verwendet, wird die Ausbreitungsgeschwindigkeit der Mikrowelle im Dielektrikum auf ein Drittel des Wertes in Luft bzw. im Vakuum herabgesetzt und durch entsprechende Dimensionierung des Dielektrikums und des Stiftes wird die Einkopplung entsprechend angepasst, so dass es nicht zur Reflektion der Wellen kommt.

Weiterhin werden die Koppelstifte zweckmäßigerweise so dimensioniert und in das Dielektrikum der Gasentladungskammer derart eingepasst, dass es zu keinem Impedanzsprung beim Übergang der Koaxialleitung zum Dielektrikum der Gasentladungskammer kommt und dadurch die gesamte Energie in das Dielektrikum eingekoppelt wird, ohne dass Reflektionsverluste auftreten. Besonders ist es vorteilhaft, wenn durch entsprechende Dimensionierung des Koppelstifts im Bereich des Dielektrikums der Gasentladungskammer und der Durchführung in den Hohlleiter dieser als elektromagnetischer Schwingkreis ausgebildet ist, wodurch die Mikrowelle besonders wirkungsvoll in die Gasentladungskammer eingespeist werden kann. Das wird z.B. dadurch erzielt, dass der Koppelstift im Bereich des Dielektrikums und der Hohlleiterdurchführung hinsichtlich seines Durchmessers und seiner Länge so ausgebildet wird, dass er als Schwingkreis bei der gegebenen Mikrowellenfrequenz wirkt. Dadurch haben die unterschiedlichsten Arbeitsbedingungen der Vorrichtung, wie etwa Druckunterschiede von 3 Zehnerpotenzen und auch unterschiedliche Prozessgase nur mehr einen zu vernachlässigenden Einfluss auf die reflektierte Leistung der Vorrichtung.

Weiter ist es vorteilhaft, dass das Ende des Koppelstifts direkt anliegend, ohne dass ein Spalt zwischen Koppelstift und Dielektrikum vorhanden ist, in das Dielektrikum eingepasst wird. Dadurch kann die Mikrowelle besonders gut und reflektionsfrei in das Dielektrikum eingespeist werden. Zudem kann die im Koaxialleiter durch Oberflächenströme der Mikrowelle erzeugte Wärme über den Koppelstift in das Dielektrikum abgeführt werden. Diese Ausführung ist besonders für Vorrichtungen mit hohen Mikrowellenleistungen geeignet. Ein weiterer Vorteil der Einkopplung der Mikrowelle durch den Koppelstift besteht darin, dass keine nachträglichen Einstellungen notwendig sind, trotz unterschiedlichster Arbeitsbedingungen der Vorrichtung hinsichtlich Leistung und Druck.

Neben der kapazitiven Einkopplung der Mikrowellenenergie in das Dielektrikum mittels des Koppelstiftes ist auch eine induktive Einkopplung mittels einer Spule möglich. Diese Methode ist besonders gut bei kleineren Frequenzen geeignet. Darüber hinaus kann die Mikrowelle auch über Hohlleiterzuführungen dem Dielektrikum zugeführt werden, insbesondere bei sehr hohen Frequenzen.

In einer bevorzugten Ausführungsform der Erfindung ist die Gasentladungskammer derart ausgebildet, dass sie den Hohlleiter im Wesentlichen ausfüllt. Hierunter ist zu verstehen, dass die Gasentladungskammer derart dimensioniert ist, das der Innenraum des Hohlleiters im Wesentlichen vollständig mit der Gasentladungskammer belegt ist. Das Dielektrikum grenzt also mit seiner Außenoberfläche an die Innenoberfläche des Hohlleiters an und innerhalb des Dielektrikums ist wiederum der Gasentladungsraum ausgebildet. Diese Ausbildungsform ist vorteilhaft, da dadurch zum einen eine kompakte Anordnung herstellbar ist, die platzsparend ist. Zum anderen wird dadurch erreicht, dass die gesamte Energie der Mikrowelle auf die Gasentladungskammer konzentriert bleibt, wo sie dann im Gasentladungsraum verbraucht wird. Der Hohlleiter ist üblicherweise metallisch ausgebildet und ist bevorzugt, insbesondere bei dieser Ausführungsform, als Kühlkörper ausgebildet, das heißt, im Hohlleiter ist eine Kühlung, insbesondere eine Wasserkühlung, vorgesehen. Er umschließt die Gasentladungskammer von ihrer stirnseitigen Basis bis hin zum Gasauslass. Da die Mikrowelle nur punktuell in die Gasentladungskammer eingekoppelt wird und ansonsten nur der relativ klein ausfallende und lokal begrenzte Einlass für das Prozessgas in die Gasentladungskammer hinein verläuft, kann die Kühlung großflächig an der Oberfläche der Gasentladungskammer anliegen und somit ein optimales Kühlergebnis erzielt werden.

Zweckmäßigerweise ist die Gasentladungskammer derart ausgebildet, dass an dem Ende des Gasentladungsraums, welches der stirnseitigen Basis gegenüberliegt, der Gasauslass für den Gasentladungsraum vorgesehen ist. Ferner ist es zweckmäßig den Gaseinlass an dem Ende des Gasentladungsraums vorzusehen, welches an die stirnseitige Basis angrenzt. Dadurch wird erreicht, dass sich eine gleichmäßige Ausbreitung des Plasmas über den gesamten Entladungsraum einstellt. Dadurch werden die thermischen Belastungen, über die gesamte Gasentladungskammer gesehen, relativ konstant gehalten, was wiederum zur Verhinderung von Beschädigungen im Dielektrikum beiträgt. Ferner ist sichergestellt, dass das gesamte, in den Gasentladungsraum eingeleitete Prozessgas von den Mikrowellen erfasst wird und sich somit ein hoher Wirkungsgrad einstellt.

Vorteilhafterweise ist die Gasentladungskammer symmetrisch mit Bezug auf die Längsachse des Hohlleiters ausgebildet. Diese Ausbildung trägt zur gleichmäßigen Verteilung der thermischen Belastung bei und vereinfacht die Herstellung der erfindungsgemäßen Vorrichtung.

Vorteilhafterweise ist die stirnseitige Basis als massiver, zylindrischer oder halbkugelförmiger Körper ausgebildet. Die Innenform des Hohlleiters ist entsprechend anzupassen, so dass dieser vorteilhafterweise direkt an der stirnseitigen Basis anliegt. Hierdurch ergibt sich eine vorteilhafte Form zur Bildung des Entladungsraumes in Zusammenwirkung mit den Seitenwänden und die in die stirnseitige Basis eingekoppelten Mikrowellen können noch gleichmäßiger durch die gesamte Gasentladungskammer verteilt werden.

In einer bevorzugten Ausführungsform der Erfindung weisen die Seitenwände der Gasentladungskammer mindestens eine Querschnittsverjüngung auf. Besonders bevorzugt ist diese Querschnittsverjüngung umlaufend ausgebildet. Durch diese mindestens eine gezielte Querschnittsverjüngung bzw. Verkleinerung des Querschnitts des Dielektrikums, welche besonders bevorzugt im Bereich des Gasauslasses vorgesehen ist, kann die in die Gasentladungskammer eingekoppelte Mikrowelle im Bereich der Querschnittsverjüngung vermehrt aus dem Dielektrikum in den Gasentladungsraum austreten, wodurch am Ende des Gasentladungsraumes bzw. der Gasentladungskammer, das heißt im Bereich des Gasauslasses, ein Entladungsmaximum verhindert wird. Ein solches Entladungsmaximum könnte dort zu Schädigungen der Gasentladungskammer führen.

Vorteilhafterweise sind mehrere Querschnittsverjüngungen vorgesehen, wobei es insbesondere vorteilhaft ist, die Verkleinerung des Querschnitts des Dielektrikums vom Gaseinlass zum Gasauslass hin stufenweise vorzusehen, da dadurch die auf der Stirnseite der Gasentladungskammer in die stirnseitige Basis eingespeiste Mikrowellenenergie stufenweise dem Gasentladungsraum zugeführt werden kann. Hierbei kann eine besonders gleichmäßige und dadurch vorteilhafte Verteilung der Mikrowellenenergie erreicht werden, wenn die Größe der Verjüngung in Richtung des Gasauslasses zunimmt, das heißt, der Querschnitt des Dielektrikums im Bereich der Verjüngung nimmt in Richtung des Gasauslasses ab.

Zweckmäßigerweise wird die mindestens eine Querschnittsverjüngung in Form einer umlaufenden Ausnehmung und insbesondere einer umlaufenden Ringnut ausgebildet. Die Ringnut kann beispielsweise ein U-förmiges Querschnittsprofil aufweisen und ist bevorzugterweise auf der Innenseite des Dielektrikums ausgebildet.

In einer weiteren bevorzugten Ausführungsform der Erfindung sind die Seitenwände der Gasentladungskammer derart ausgebildet, dass sich ihr Querschnitt in Richtung des Gasauslasses beständig verjüngt. Dies bedeutet, dass vom Anfang der Seitenwände an der stirnseitigen Basis bis zu Ihrem Ende am Gasauslass ihr Querschnitt fortwährend verkleinert wird. Diese fortwährende Verkleinerung des Querschnitts kann mit einem konstanten Verkleinerungsgrad oder auch mit bereichsweise unterschiedlichen Verkleinerungsgraden vorgesehen werden. Bevorzugt ist der Grad der Querschnittsverjüngung konstant. Dies kann beispielsweise durch eine kegelförmige Ausbildung des Entladungsraumes erreicht werden, wobei die Außenseiten der Seitenwände parallel zueinander auszubilden sind. Dadurch tritt die Mikrowelle gleichmäßig aus dem sich verjüngenden Querschnitt des Dielektrikums aus, wodurch das Prozessgas gleichmäßig über den gesamten Kegelraum angeregt wird. Weiterhin ist bei dieser Ausführungsform vorteilhaft, dass die Steilheit des Kegels den Raumwinkel vorgibt, unter dem die angeregten Gase aus dem Gasentladungsraums austreten, wenn der Gasauslass so ausgebildet ist, dass er über die gesamte Breite des Kegelbodens verläuft. Der Raumwinkel kann so vorgegeben werden, dass sich die angeregten Prozessgase möglichst gleichmäßig über ein jeweiliges Werkstück verteilen.

In einer weiteren bevorzugten Ausführungsform der Erfindung weisen die Seitenwände der Entladungskammer mindestens einen, insbesondere umlaufend ausgebildeten, Vorsprung auf. Der Vorsprung steht von der dem Hohlleiter zugewandten Seite der Seitenwände vor und der Umfang des in der Regel U-förmigen Querschnitts des Vorsprungs über die Seitenwand hinaus entspricht der halben Wellenlänge der elektromagnetischen Welle (λ/2) im Dielektrikum. Im Falle eines U-förmigen Querschnitts setzt sich der Umfang also aus den addierten Längen der beiden U-Schenkel und des Verbindungsstücks zwischen den U-Schenkeln zusammen. Grundsätzlich kann der Querschnitt des Vorsprungs auch jede andere, beliebige Form aufweisen, wobei aber immer darauf zu achten ist, dass der Querschnittsumfang λ/2 entspricht. Der mindestens eine Vorsprung wirkt als Sperrelement für Mikrowellen und dient der Begrenzung der Ausbreitung der Mikrowellen. Daher wird der mindestens eine Vorsprung zweckmäßigerweise am Gasauslass und somit in Gasströmungsrichtung am Ende der Gasentladungskammer vorgesehen. Dadurch kann die Ausbreitung der Mikrowelle am Ende der Gasentladungskammer, das heißt im Bereich des Gasauslasses, begrenzt werden. Dadurch wird verhindert, dass die Mikrowellen aus der Gasentladungskammer aus- und in den dahinter geschalteten Bearbeitungs- oder Reaktionsraum, in dem ein Werkstück zur Bearbeitung durch die angeregten Prozessgase anzuordnen ist, eintreten können, was sich negativ auf den Bearbeitungsvorgang auswirken würde. Besonders bevorzugt ist der mindestens eine Vorsprung als umlaufender Wulst und insbesondere als Dielektrikumring relativ geringer Breite ausgebildet. Der Dielektrikumring wird auf die Dielektrikumseitenwände aufgesetzt. Dadurch, dass der, vorteilhafterweise U-förmig ausgebildete, mindestens eine Vorsprung einen Querschnittsumfang von der halben Wellenlänge der Mikrowelle hat, wird auf der einen Seite des Vorsprungs eine positive und auf der anderen eine negative Halbwelle erzeugt, die sich überlagern und so zu Null kompensieren. Dies führt dazu, dass verhindert wird, dass die elektromagnetischen Wellen das der stirnseitigen Basis entgegengesetzte Ende der Entladungskammer erreichen und dort zu Schädigungen führen können. Bei besonders hohen Mikrowellenleistungen ist es insbesondere bevorzugt, Sperrelemente mit Querschnittsverjüngungen der Seitenwände zu kombinieren, so dass die Energie bis zum Gasauslass hin zuverlässig im Gasentladungsraum verbraucht wird. Ebenso kann der mindestens eine Vorsprung bei einer erfindungsgemäßen Vorrichtung vorgesehen sein, deren Seitenwände mit einem sich in Richtung des Gasauslasses beständig verjüngenden Querschnitt ausgebildet sind.

In einer weiteren bevorzugten Ausführungsform ist an den Innenseiten der Seitenwände mindestens eine, insbesondere umlaufend ausgebildete Schulter vorgesehen. Besonders bevorzugt sind mehrere Schultern hintereinander angeordnet, so dass sich eine pyramidenförmige Abstufung des Gasentladungsraums ergibt. Zweckmäßigerweise sind die Abstufungen so vorgesehen, dass sich der Gasentladungsraum in Gasauslassrichtung aufweitet. Die Länge der Schultern entspricht einem Weg der elektromagnetischen Welle von λ/4 im Dielektrikum. Dadurch werden an den Schultern ein Vielzahl von Maxima erzeugt, die aus der vorlaufenden elektromagnetischen Welle und der an den Schultern der Seitenwände reflektierten, rücklaufenden elektromagnetischen Welle gebildet werden, wobei die Effektivität der Gasentladung in den Maxima gezielt verbessert und außerdem die Mikrowellenenergie in gleichmäßigen Abständen auf den Gasentladungsraum verteilt werden kann. Bei einem pyramidenförmig abgestuften Entladungsraum ist der Raumwinkel, unter dem die Gase aus diesem Raum austreten, vorgebbar und entspricht der Steigung der Pyramide. Dazu ist der Gasauslass so auszubilden, dass er sich über den gesamten Boden der abgestuften Pyramide erstreckt. Der Raumwinkel ist somit an die Dimensionen der zu behandelnden Werkstücke anpassbar. Anstelle von λ/4 kann die Länge der Schultern auch λ/4 + nλ, mit n = 1, 2, 3,..., betragen.

Der Hohlleiter ist bevorzugterweise im Wesentlichen quaderförmig, zylindrisch, elliptisch oder kegelförmig ausgebildet. Ist der Hohlleiter kreiszylindrisch ausgebildet, wird der Durchmesser des Hohlleiters im Bereich der stirnseitigen Basis zweckmäßigerweise so gewählt, dass er größer als die Grenzwellenlänge der elektromagnetischen Welle ist und somit eine Ausbreitung der elektromagnetischen Welle in mindestens dem Grundmodus möglich ist. Die Feldkonfiguration der elektromagnetischen Welle in zylindrischen Hohlleitern werden am besten in Zylinderkoordinaten dargestellt. In Zylinderkoordinaten liefert die Lösung der Wellengleichung die Besselfunktionen. Auch im Bereich des Entladungsraums der Gasentladungskammer ist sein Durchmesser so zu wählen, dass er größer ist als die Grenzwellenlänge der Mikrowelle. Ist der Hohlleiter quaderförmig ausgebildet, ist die Breite des Hohlleiters zweckmäßigerweise so vorzugeben, dass sie größer als λ/2 der elektromagnetischen Welle ist. Durch die entsprechende Wahl des Durchmessers des runden Hohlleiters bzw. der Breite des quaderförmigen Hohlleiters wird die Ausbildung einer vorteilhaften Anzahl von Moden der elektromagnetischen Welle ermöglicht.

Weiterhin kann der Hohlleiter so ausgebildet sein, dass er bereichsweise verschiedene Formen aufweist. Gemäß einer weiteren bevorzugten Ausführungsform ist der Hohlleiter im Bereich der stirnseitigen Basis zylindrisch ausgebildet und weitet sich im weiteren Bereich des Gasentladungsraums kegelförmig auf, um eine Gasentladungskammer mit einem Brennraum bzw. Gasentladungsraums mit besonders großem Raumwinkel zu ermöglichen. Dadurch können großflächige Werkstücke, wie etwa Halbleiterscheiben mit einem Durchmesser von 300 mm sehr gleichmäßig mit angeregten Gasen prozessiert werden. In einer besonders vorteilhaften Ausführungsform der Erfindung ist der Gasentladungsraum der Gasentladungskammer ebenfalls kegelförmig ausgeführt und der Querschnitt der Seitenwände des Dielektrikums verjüngt sich gleichmäßig in Richtung des Gasauslasses, so dass die Mikrowelle gleichmäßig austreten kann. Am Ende des Gasentladungsraums ist ein Mikrowellensperrelement in Form einer umlaufenden Ringwulst vorgesehen. Weiterhin ist es bei dieser Ausführungsform auch möglich, auf der Innenseite der Seitenwände Schultern vorzusehen. Der Querschnitt des die Gasentladungskammer umgebenden Hohlleiters ist vorteilhafterweise rund, elliptisch oder auch rechteckig ausgebildet.

Entsprechend den jeweiligen Anforderungen hinsichtlich der Größe der zu bearbeitenden Werkstücke und der erforderlichen Mikrowellenleistung, können unterschiedlich große Anregungskammern gebaut werden und dazu die entsprechend geeigneten Mikrowellenfrequenzen (beispielsweise 915 MHz, 2,45 GHz oder 5,8 GHz) ausgewählt werden. Das heißt beispielsweise, dass die 915 MHz-Vorrichtung bei gleicher Bauart ca. sechs mal größer ist als die 5,8 GHz-Vorrichtung.

In einer weiteren bevorzugten Ausführungsform ist die Gasentladungskammer mittels einer Presspassung in den Hohlleiter eingepasst. Dadurch kann die bei der Gasentladung entstehende Wärme mittels der Presspassung des Kühlmantels auf der Gasentladungskammer besonders gut zur Kühlflüssigkeit weitergeleitet werden, wodurch eine sehr gute Kühlung der Gasentladungskammer ermöglicht wird.

Im Folgenden werden einige typische Anwendungsbeispiele von gemäß der vorliegenden Erfindung ausgebildeten Hochleistungsplasmavorrichtungen angeführt.

Remote-Plasmaquellen
Prozesse *für die Reinigung von Beschichtungskammern und Ätzkammern:*

| | |
|---|---|
| Mikrowellenleistung: | 2 bis 30 kW, bevorzugt 2 bis 6 kW |
| Frequenz: | 2,45 GHz bzw. 915 MHz |
| Druck: | 0,5 bis 5 Torr |
| Gase: | NF₃, C₂F₆+O₂, SF₆+O₂, Cl₂+NF₃ |

Plasmaquellen mit kegelförmigem Gasaustritt und relativ großem Raumwinkel
*Strippen von Fotolacken und Ätzen von Werkstücken:*

| | |
|---|---|
| Mikrowellenleistung: | 0,5 bis 30 kW, bevorzugt 0,5 bis 4 kW |
| Frequenz: | 2,45 GHz bzw. 915 MHz |
| Druck: | 0,1 bis 5 Torr |
| Gase: | O₂, N₂, Formiergas, NF₃, CF₄ |

*Aktivieren und Reinigen von Oberflächen:*

| | |
|---|---|
| Mikrowellenleistung: | 0,5 bis 30 kW, bevorzugt 0,5 bis 4 kW |
| Frequenz: | 2,45 GHz |
| Druck: | 0,05 bis 5 Torr |
| Gase: | O₂, N₂, H₂, Formiergas, CF₄, Ar |

Die Aufgabe wird ferner durch ein Verfahren zur Erzeugung angeregter und/oder ionisierter Teilchen in einem Plasma aus einem Prozessgas gelöst, bei dem eine elektromagnetische Welle erzeugt und in ein Dielektrikum einer Gasentladungskammer eingekoppelt wird, wobei im Dielektrikum eine Gasentladungskammer ausgebildet ist, die einen Gaseinlass und Gasauslass zum Zu- bzw. Abführen von Prozessgas aufweist. Weiterhin wird die elektromagnetische Welle in eine stirnseitige Basis des Dielektrikums eingekoppelt, wobei der Gasentladungsraum zwischen der stirnseitigen Basis und dem Gasauslass angeordnet ist. Ferner wird bei dem Verfahren bevorzugterweise durch geeignete Ausgestaltung des Dielektrikums die Energie der in der stirnseitigen Basis in die Gasentladungskammer eingekoppelten elektromagnetischen Welle im Gasentladungsraum bis Erreichen des Gasauslasses verbraucht.

Im Folgenden wird die Erfindung anhand in der Zeichnung dargestellter Ausführungsbeispiele näher erläutert. Es zeigen schematisch:
- Fig. 1: eine Vorrichtung zur Erzeugung angeregter und/oder ionisierter Teilchen in einem Plasma mit Querschnittsverjüngungen in den Seitenwänden;
- Fig. 2: die Vorrichtung aus Fig. 1, bei der anstelle der Querschnittsverjüngungen nach außen von den Seitenwänden vorstehende Vorsprünge ausgebildet sind;
- Fig. 3: eine Vorrichtung zur Erzeugung angeregter und/oder ionisierter Teilchen in einem Plasma mit hintereinander angeordneten, treppenförmigen Schultern;
- Fig. 4: eine Vorrichtung zur Erzeugung angeregter und/oder ionisierter Teilchen in einem Plasma, dessen Seitenwände einen sich beständig verjüngenden Querschnitt aufweisen;
- Fig. 5: eine Vorrichtung zur Erzeugung angeregter und/oder ionisierter Teilchen in einem Plasma, mit einem teilweise kegelförmigen Hohlleiter;
- Fig. 6: die Vorrichtung aus Fig. 5, wobei an der Innenseite der Seitenwände hintereinander angeordnete, treppenförmige Schultern vorgesehen sind;
- Fig. 7: die Vorrichtung aus Fig. 6, wobei der gesamte Hohlleiter kegelförmig ausgebildet ist;
- Fig. 8: eine Vorrichtung zur Erzeugung angeregter und/oder ionisierter Teilchen in einem Plasma, bei der der Koaxialleiter die Mikrowelle seitlich in die stirnseitige Basis einkoppelt;
- Fig. 9: eine Vorrichtung zur Erzeugung angeregter und/oder ionisierter Teilchen in einem Plasma, bei der der Koaxialleiter die elektromagnetische Welle schräg von oben in die stirnseitige Basis einkoppelt;
- Fig. 10: die Vorrichtung aus Fig. 8, wobei die Einkopplung von oben vorgenommen wird;
- Fig. 11: die Vorrichtung aus Fig. 9, wobei die Mikrowelle induktiv eingekoppelt wird;
- Fig. 12: die Vorrichtung gemäß Fig. 8, wobei die Mikrowelle mittels einer Hohlleiterzuleitung von der Seite eingekoppelt wird; und
- Fig. 13: die Vorrichtung aus Fig. 12, wobei die Einkopplung von oben vorgenommen wird.

Bei den im Folgenden beschriebenen, verschiedenen Ausführungsformen sind für gleiche Teile gleiche Bezugszeichen verwendet. Sämtliche in den Figuren gezeigten Darstellungen sind Längsschnitte durch die erfindungsgemäße Vorrichtung.

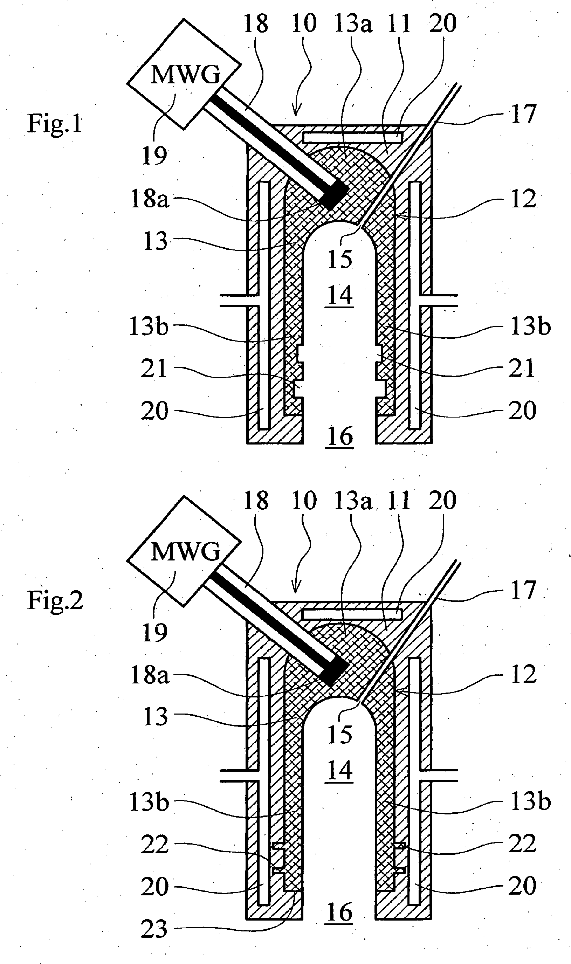

Fig. 1 zeigt eine Vorrichtung 10 zur Erzeugung angeregter und/oder ionisierter Teilchen in einem Plasma aus einem Prozessgas. Die Plasmaerzeugungsvorrichtung 10 umfasst einen kreiszylindrisch ausgebildeten Hohlleiter 11, der aus einem geeignetem Material, insbesondere aus einem Metall, hergestellt ist. Der Hohlleiter 11 weist einen ebenfalls kreiszylindrischen und an seinem stirnseitigen, geschlossenen Ende halbkugelförmig ausgebildeten Hohlraum auf, in dem die Gasentladungskammer 12 angeordnet ist. Die Gasentladungskammer 12 besteht wiederum aus einem Körper aus Dielektrikum 13 und einem im Dielektrikum 13 ausgebildeten Gasentladungsraum 14. Das Dielektrikum 13 liegt mit seiner gesamten Außenoberfläche an der Innenseite des Hohlleiters 11 an. Das Dielektrikum 13 besteht aus einer stirnseitigen Basis 13a und Seitenwänden 13b, die von der stirnseitigen Basis 13a abgehen und einen Hohlraum bzw. Gasentladungsraum 14 bilden. Die stirnseitige Basis 13a liegt an einem geschlossenen Ende des Hohlleiters 11 an. Die Seitenwände 13b sind umlaufend ausgebildet. Ferner sind die Seitenwände 13b in Umfangsrichtung mit einer konstanten Breite ausgebildet und die Innen- und Au-βenseiten der Seitenwände 13b sind im Wesentlichen parallel zueinander. Sowohl Hohlleiter 11 als auch Dielektrikum 13 weisen ein offenes, freies Ende auf, wobei die Dimensionen der Öffnungen jeweils im Wesentlichen gleich sind und beide Öffnungen deckungsgleich übereinander angeordnet sind. Diese Öffnungen bilden den Gasauslass 16. Der Durchmesser des Gasauslasses 16 entspricht im Wesentlichen dem Durchmesser des Gasentladungsraums 14. Er ist der stirnseitigen Basis 13a gegenüberliegend angeordnet. Der Gaseinlass 15 ist wiederum direkt an der stirnseitigen Basis 13a ausgebildet und mit einer Gaszuführung 17 verbunden, über die Gas in den Gasentladungsraum 14 eingebracht wird.

Im Hohlleiter 11 ist eine Öffnung vorgesehen, durch die ein Koaxialleiter 18 verläuft, der in der stirnseitigen Basis 13a des Dielektrikums 13 endet. Der Koaxialleiter 18 weist an seinem Ende einen Koppelstift 18a auf, der derart in die stirnseitige Basis 13a eingepasst ist, dass er zu allen Seiten am Dielektrikum 13 anliegt. Dieser Koaxialleiter 18 ist mit einem Mikrowellengenerator 19 verbunden. Vom Mikrowellengenerator 19 werden die erzeugten Mikrowellen über den Koaxialleiter 18 und mittels dessen Koppelstifts 18a in die stirnseitige Basis 13a eingekoppelt. Von dort aus breiten sich die Mikrowellen durch die gesamte Gasentladungskammer 12 aus. Der Koaxialleiter 18 wird von schräg oben links in die Plasmaerzeugungsvorrichtung eingebracht. Im Hohlleiter 11 sind sowohl in seinem stirnseitigen Bereich als auch in den Seitenwänden Kühlleitungen 20 vorhanden, in denen Kühlflüssigkeit, insbesondere Wasser, zur Kühlung der Gasentladungskammer 11 entlang fließt. Die Kühlleitungen 20 decken im Wesentlichen den gesamten Oberflächenbereich der Gasentladungskammer 12 ab und werden nur durch den Koaxialleiter 18 sowie die Gaszuführung 17 lokal unterbrochen. Auf der Innenseite des Seitenwände 13b des Dielektrikums 13 sind zwei umlaufende Ringnuten 21 vorgesehen. Die Ringnuten 21 weisen einen rechteckigen Querschnitt auf und sind, in Längsrichtung betrachtet, in der dem Gasauslass 16 zugewandten Bereich der Seitenwände 13b angeordnet. Die obere Ringnut weist eine geringere Tiefe auf als die untere, das heißt, die Dicke des Dielektrikums im Bereich der unteren Ringnut ist geringer als im Bereich der oberen Ringnut.

Die in Fig. 2 dargestellte Plasmaerzeugungsvorrichtung 10 weist im Gegensatz zu der aus Fig. 1 keine Querschnittsverjüngung bzw. Ringnuten 21 auf. Stattdessen sind am Dielektrikum 13 zwei umlaufend ausgebildete Vorsprünge vorgesehen, die als umlaufende Ringwulste 22 ausgebildet sind. Die Ringwulste 22 sind am unteren Ende der Seitenwände 13b im Bereich des Gasauslasses 16 vorgesehen. Sie stehen von der Oberfläche der Außenseite der Seitenwände 13b vor. Im Hohlleiter 11 sind entsprechende Ausnehmungen vorgesehen, die die Ringwulste 22 formschlüssig einfassen. Die Ringwulste 22 weisen einen U-förmigen Querschnitt auf und stehen im Wesentlichen orthogonal auf den Seitenwänden 13b. Ihr Querschnitt ist so dimensioniert, dass der Umfang des Wulstquerschnitts einem Weg der elektromagnetischen Welle von λ/2 entspricht, so dass die Überlagerung der positiven und negativen Halbwellen sich zu Null kompensiert und verhindert wird, dass die elektrische Welle das untere Ende der Entladungskammer 23 erreicht. Die in Fig. 1 und Fig. 2 dargestellten Ausführungsformen der vorliegenden Erfindung sind besonders vorteilhaft geeignet für sogenannte "Remote-Plasmaquellen".

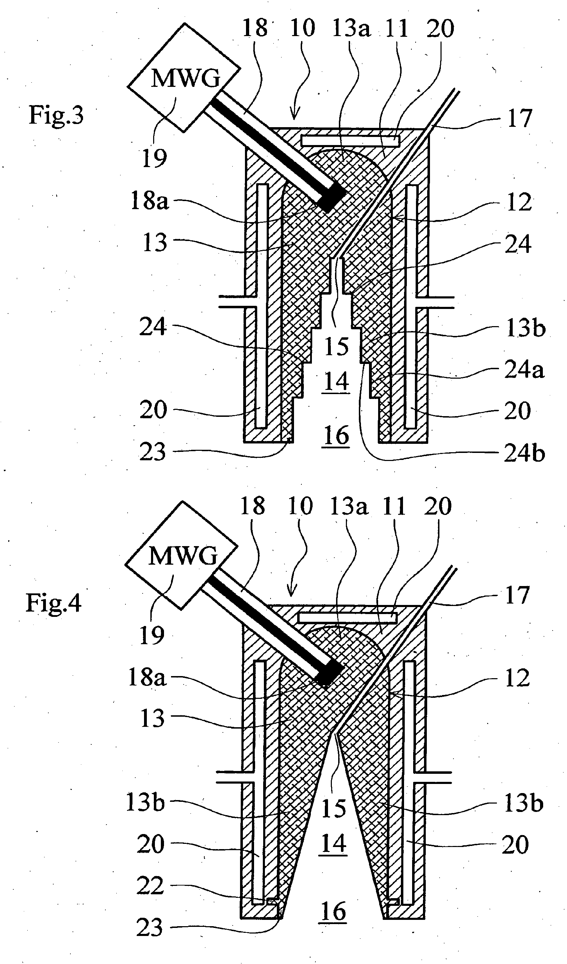

Bei der in Fig. 3 gezeigten Plasmaerzeugungsvorrichtung 10 sind an der Innenseite der Seitenwände 13b Schultern 24 vorgesehen. Die Schultern 24 sind von der stirnseitigen Basis 13a bis hin zum Gasauslass 16 aneinandergereiht angeordnet und umlaufend ausgebildet, so dass sich pyramiden- bzw. treppenförmige Abstufungen des Gasentladungsraums 14 ergeben, wobei sich der Gasentladungsraum 14 zum Gasauslass 16 hin aufweitet. Eine Schulter umfasst jeweils eine vertikale und eine horizontale Flanke 24a, 24b, die im Wesentlichen orthogonal aufeinander stehen. Die Länge der Vertikalflanke 24a beträgt λ/4 des Weges der elektromagnetischen Welle. Dadurch ist die Energie der in die stirnseitige Basis 13a eingeleiteten Mikrowellen bis hin zum offenen Ende 23 der Gasentladungskammer 12 aufgebraucht.

Bei der in Fig. 4 dargestellten Vorrichtung 10 ist der Gasentladungsraum 14 kegelförmig ausgebildet, wobei die Spitze des Kegels an die stirnseitige Basis 13a grenzt und der Boden des Kegels den Gasauslass 16 bildet. Durch die kegelförmige Ausbildung des Gasentladungsraums 14 bei gleichzeitiger vertikaler und zueinander paralleler Ausrichtung der Außenseiten der Seitenwände 13b ergibt sich eine fortwährende Verjüngung der Seitenwände 13b von der stirnseitigen Basis 13a in Richtung des Endes der Gasentladungskammer 23. Am Ende der Gasentladungskammer 23 ist ein als Ringwulst ausgebildetes Sperrelement 22 vorgesehen. Sowohl bei Fig. 3 als auch bei Fig. 4 treten die angeregten Gase jeweils unter einem bestimmten Raumwinkel, der durch die Steigerung des Kegels bzw. der abgestuften Pyramide vorgegeben ist, aus der Vorrichtung 10 aus. Dadurch bietet es sich bei diesen Vorrichtungen an, direkt im Anschluss an den Gasauslass die Reaktionskammer mit dem zu bearbeitenden Werkstück anzuordnen und das Werkstück so unter dem Gasauslass 16 anzuordnen, dass es vollständig von den angeregten Gasen abgedeckt wird.

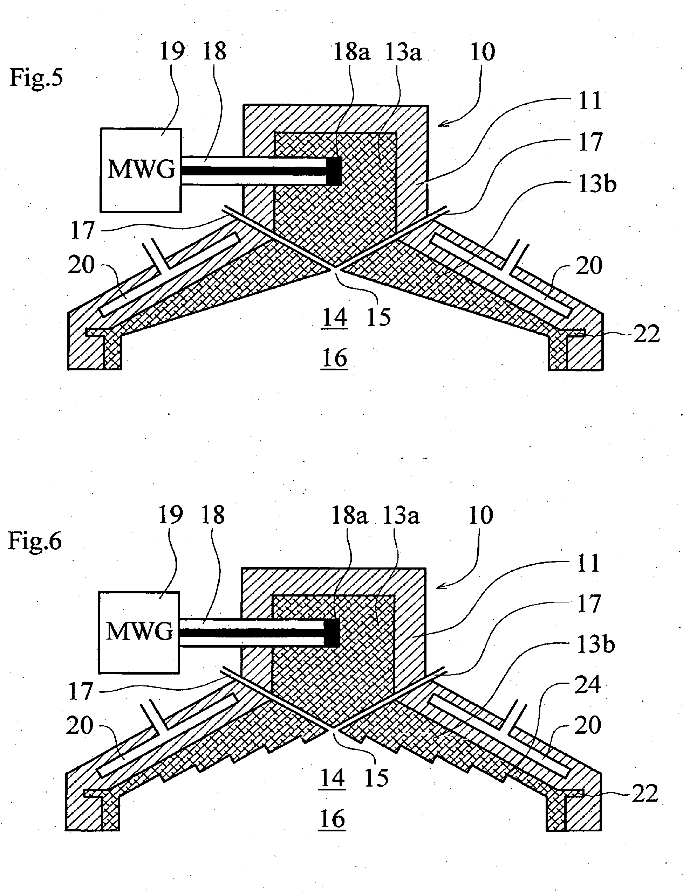

Fig. 5 zeigt eine Plasmaerzeugungsvorrichtung 10, bei der der Hohlleiter 11 im Bereich der stirnseitigen Basis 13a kreiszylinderförmig und im restlichen Bereich, das heißt, in dem Bereich, der die Seitewände 13b umgibt, kegelförmig ausgebildet ist. Ferner sind die Seitenwände 13b, entsprechend der Vorrichtung aus Fig. 4 so ausgebildet, dass sich ihr Querschnitt in Richtung des Gasauslasses 16 verjüngt. Durch die kegelförmige Ausbildung sowohl des Hohlleiters als auch des Gasentladungsraums 14 ist mit der Vorrichtung 10 aus Fig. 5 ein besonders großer Raumwinkel erzielbar, unter dem das angeregte Gas aus dem Entladungsraum 14 austritt. Ferner sind im Bereich des Gasauslasses 16 als Sperrelement wirkende, umlaufende Ringwulste 22 vorgesehen.

Die in Fig. 6 gezeigte Vorrichtung 10 ist ähnlich derjenigen aus Fig. 5 ausgebildet. Ein Unterschied liegt darin, dass an der Innenseite der Seitenwände 13b treppenförmige Schultern 24 vorgesehen sind. Dadurch werden regelmäßige Zonen besonders hoher Plasmadichte erzeugt, was hinsichtlich der zu erwartenden Prozessergebnisse besonders vorteilhaft ist. Um eine Ausbreitung der Mikrowelle über die Entladungskammer hinaus zu unterbinden, ist auch bei dieser Vorrichtung eine umlaufende Ringwulst 22 im Bereich des Gasauslasses 16 vorgesehen. Bei den in Fig. 5 und Fig. 6 dargestellten Vorrichtungen 10 wird der Koaxialleiter, bzw. die daran angebrachten Koppelstifte 18a, seitlich in die stirnseitige Basis 13a eingebracht. Bei der Ausgestaltung der stirnseitigen Basis 13a ist darauf zu achten, dass eine Form gewählt wird, die eine reflektionsfreie Einkopplung der Mikrowellenenergie erlaubt.

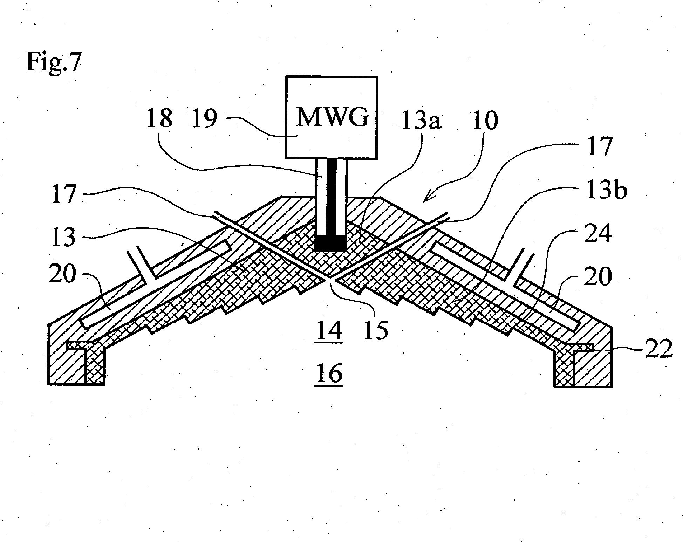

Die Vorrichtung aus Fig. 7 ist ähnlich derjenigen aus Fig. 6 ausgebildet, wobei im Unterschied dazu sowohl der gesamte Hohlleiter 11 als auch das gesamte Dielektrikum 13 kegelförmig ausgebildet sind. Das bedeutet, dass die stirnseitige Basis 13a den Spitzenbereich des Kegels des Dielektrikums 13 bildet. Ferner sind im vorliegenden Fall zwei Gaszuführungen 17 angeordnet, die jeweils schräg von oben in die Vorrichtung 10 hineinverlaufen und im oberen Endpunkt des Gasentladungsraums 14 enden. Ferner wird im Gegensatz zu Fig. 6 der Koaxialleiter 18 senkrecht von oben in die Vorrichtung 10 eingebracht.

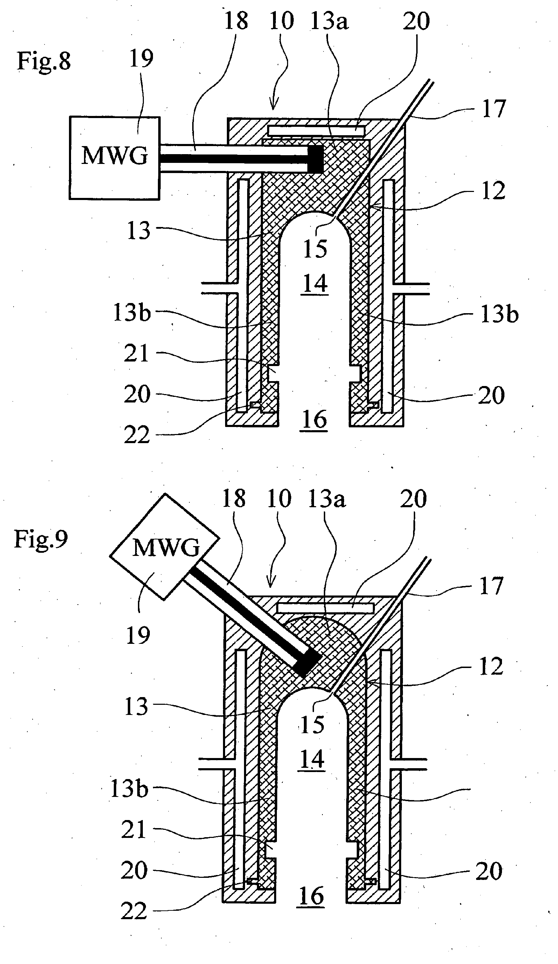

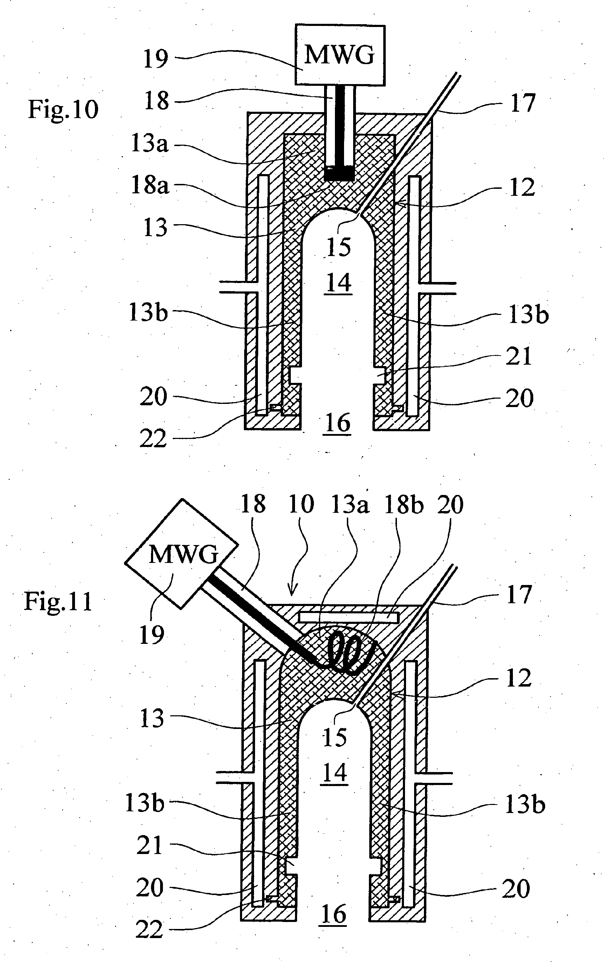

Die Fig. 8 und 10 zeigen jeweils eine Vorrichtung 10, bei der die stirnseitige Basis 13a als kreiszylindrischer Körper ausgebildet ist, der vollständig aus Dielektrikum besteht. Daran schließen sich die Seitenwände 13b unter Bildung des Gasentladungsraums 14 an. Die Seitenwände 13b weisen eine Ringnut 21 und einen Ringwulst 22 auf. Der obere Endbereich des Gasentladungsraums 14 ist halbkugelförmig ausgebildet und grenzt mit seiner Stirnfläche an die stirnseitige Basis 13a an. In Fig. 8 wird der Koaxialleiter 18 seitlich und in Fig. 10 senkrecht von oben in die stirnseitige Basis 13a eingebracht.

Bei den Fig. 9 und 11 ist im Gegensatz zu den Vorrichtungen aus Fig. 8 und 10 die stirnseitige Basis 13a halbkugelförmig ausgebildet. Die halbkugelförmige Ausbildung der stirnseitigen Basis der Gasentladungskammer ist für eine Einkopplung der Mikrowelle von schräg oben besonders geeignet, da die reflektierte Leistung bei allen Anwendungen der Vorrichtung besonders gering ist. Ferner ist in Fig. 11 statt eines Koppelstifts eine Spule 18b vorgesehen. Daher wird die Einkopplung der Mikrowellenenergie in die stirnseitige Basis 13a bei der Vorrichtung aus Fig. 11 induktiv vorgenommen. Bei beiden Vorrichtungen wird der Koaxialleiter 18 jeweils von schräg oben links in die Vorrichtung 10 eingebracht.

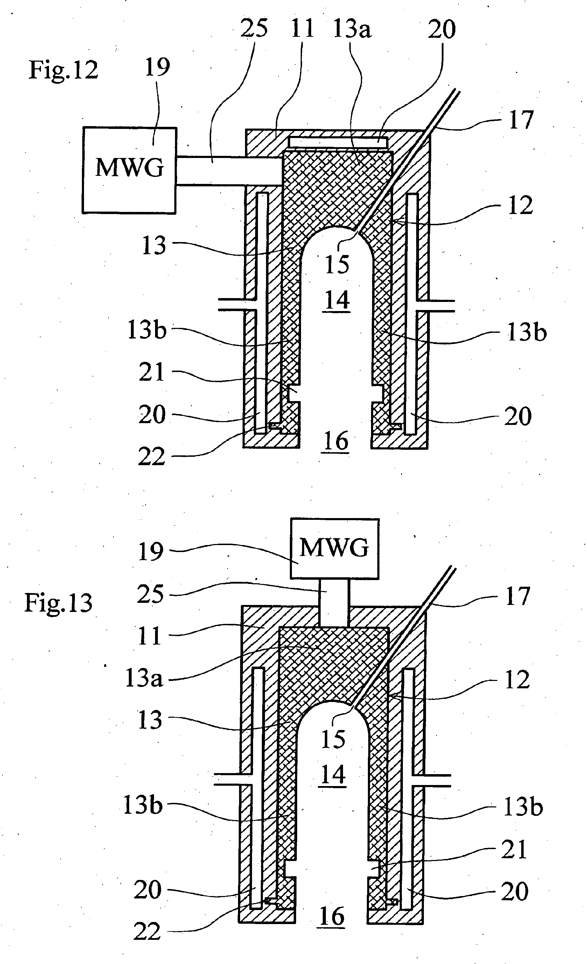

Bei den Vorrichtungen aus den Fig. 12 und 13 wird die Mikrowelle von dem Mikrowellenerzeugungsgerät 19 jeweils über eine Hohlleiterzuleitung 25 in die stirnseitige Basis 13a eingekoppelt. Die Hohlleiterzuleitungen 25 sind so ausgebildet, dass sie durch eine Ausnehmung im Hohlleiter 11 hindurch verlaufen und am äußeren Randbereich der stirnseitigen Basis 13a enden. Bei der Vorrichtung aus Fig. 12 wird die Hohlleiterzuleitung 25 seitlich und bei der Vorrichtung aus Fig. 13 senkrecht von oben in die Vorrichtung 10 eingebracht.

## Patentansprüche

1. Vorrichtung zur Erzeugung angeregter und/oder ionisierter Teilchen in einem Plasma aus einem Prozessgas, aufweisend:
einen Generator (19) zur Erzeugung einer elektromagnetischen Welle;
einen Hohlleiter (11); und
eine Gasentladungskammer (12) mit einem Gasentladungsraum (14), in dem die angeregten und/oder ionisierten Teilchen gebildet werden, und mit einem Dielektrikum (13), in dem der Gasentladungsraum (14) ausgebildet ist, wobei die Gasentladungskammer (12) innerhalb des Hohlleiters (11) angeordnet ist,
wobei das Dielektrikum (13) eine stirnseitige Basis (13a) ausbildet, von der sich unter Bildung des Gasentladungsraums (14) Seitenwände (13b) erstrecken; und
wobei die elektromagnetische Welle in die stirnseitige Basis (13a) einkoppelbar ist,
**dadurch gekennzeichnet,**
**dass** die Vorrichtung einen Koaxialleiter (18) aufweist; und dass der Koaxialleiter (18) zumindest teilweise im Dielektrikum (13) eingebettet angeordnet ist
und an seinem Ende einen Koppelstift (18a) oder eine Koppelspule (18b) aufweist, der/die im Dielektrikum (13) eingebettet angeordnet ist, und dass die elektromagnetische Welle in die stirnseitige Basis (13a) mittels des Koppelstifts (18a) oder der Koppelspule (18b) des Koaxialleiters (18) einkoppelbar ist.

2. Vorrichtung gemäß Anspruch 1,
**dadurch gekennzeichnet,**
**dass** die Gasentladungskammer (12) den Hohlleiter (11) im Wesentlichen ausfüllt.

3. Vorrichtung gemäß Anspruch 1 oder 2 mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** der Gasauslass (16) am der stirnseitigen Basis (13a) gegenüberliegendem Ende des Gasentladungsraums (14) vorgesehen ist.

4. Vorrichtung gemäß Anspruch 3,
**dadurch gekennzeichnet,**
**dass** der Gaseinlass (15) am der stirnseitigen Basis (13a) zugewandten Ende des Gasentladungsraums (14) vorgesehen ist.

5. Vorrichtung gemäß einem der vorhergehenden Ansprüche,
**dadurch gekennzeichnet,**
**dass** die Gasentladungskammer (12) symmetrisch mit Bezug auf die Längsachse des Hohlleiters (11) ausgebildet ist.

6. Vorrichtung gemäß einem der vorhergehenden Ansprüche,
**dadurch gekennzeichnet,**
**dass** die stirnseitige Basis (13a) als zylindrischer oder halbkugelförmiger Körper ausgebildet ist.

7. Vorrichtung gemäß einem der vorhergehenden Ansprüche,
**dadurch gekennzeichnet,**
**dass** die Seitenwände (13b) der Gasentladungskammer (12) mindestens eine, insbesondere umlaufend ausgebildete, Querschnittsverjüngung (21) aufweisen.

8. Vorrichtung gemäß Anspruch 7 mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** die mindestens eine Querschnittsverjüngung (21) im Bereich des Gasauslasses (16) vorgesehen ist.

9. Vorrichtung gemäß Anspruch 7 oder 8 mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** mehrere Querschnittsverjüngungen (21) vorgesehen sind, wobei die Größe der Verjüngungen (21) in Richtung des Gasauslasses (16) zunimmt.

10. Vorrichtung gemäß einem der Ansprüche 7 bis 9,
**dadurch gekennzeichnet,**
**dass** die mindestens eine Querschnittsverjüngung (21) in Form einer umlaufenden Ringnut ausgebildet ist.

11. Vorrichtung gemäß einem der vorhergehenden Ansprüche mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** die Seitenwände (13b) der Gasentladungskammer (12) derart ausgebildet sind, dass sich ihr Querschnitt in Richtung des Gasauslasses (16) beständig verjüngt.

12. Vorrichtung gemäß einem der vorhergehenden Ansprüche,
**dadurch gekennzeichnet,**
**dass** die Seitenwände (13b) der Gasentladungskammer (12) mindestens einen, insbesondere umlaufend ausgebildeten, Vorsprung (22) aufweisen, der von der dem Hohlleiter (11) zugewandten Seite der Seitenwände (13b) vorsteht und dessen Querschnittsumfang der halben Wellenlänge der elektromagnetischen Welle entspricht.

13. Vorrichtung gemäß Anspruch 12 mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** der mindestens eine Vorsprung (22) im Bereich des Gasauslasses (16) vorgesehen ist.

14. Vorrichtung gemäß Anspruch 12 oder 13,
**dadurch gekennzeichnet,**
**dass** der mindestens eine Vorsprung (22) als umlaufender Wulst ausgebildet ist.

15. Vorrichtung gemäß einem der vorhergehenden Ansprüche,
**dadurch gekennzeichnet,**
**dass** an der dem Gasentladungsraum (14) zugewandten Seite der Seitenwände (13b) mindestens eine, insbesondere umlaufend ausgebildete, Schulter (24) vorgesehen ist, dessen Länge (24a) einem Viertel der Wellenlänge der elektromagnetischen Welle entspricht.

16. Vorrichtung gemäß Anspruch 15 mit einem Gaseinlass (15) und einem Gasauslass (16) zum Zu- bzw. Abführen von Prozessgas in den bzw. aus dem Gasentladungsraum (14),
**dadurch gekennzeichnet,**
**dass** der Gasauslass (16) am der stirnseitigen Basis (13a) gegenüberliegenden Ende des Gasentladungsraumes (14) vorgesehen ist; und
**dass** mehrere umlaufend ausgebildete Schultern (24) treppenförmig hintereinander derart angeordnet sind, dass sich der Gasentladungsraum (14) in Gasauslassrichtung aufweitet.

17. Vorrichtung gemäß einem der vorhergehenden Ansprüche,
**dadurch gekennzeichnet,**
**dass** der Hohlleiter (11) im Wesentlichen quaderförmig, zylindrisch oder kegelförmig ausgebildet ist.

18. Vorrichtung gemäß Anspruch 17,
**dadurch gekennzeichnet,**
**dass** der Hohlleiter (11) quaderförmig ausgebildet ist, wobei die Breite des Hohlleiters (11) größer als die Hälfte der Wellenlänge der elektromagnetischen Welle ist.

19. Vorrichtung gemäß Anspruch 17,
**dadurch gekennzeichnet,**
**dass** der Hohlleiter (11) als Kreiszylinder ausgebildet ist, wobei der Durchmesser des Zylinders größer als die Grenzwellenlänge der elektromagnetischen Welle ist.

20. Vorrichtung gemäß einem der vorhergehenden Ansprüche,
**dadurch gekennzeichnet,**
**dass** der Hohlleiter (11) bereichsweise verschiedenförmig ausgebildet ist.

21. Vorrichtung gemäß Anspruch 20,
**dadurch gekennzeichnet,**
**dass** der Hohlleiter (11) im Bereich der stirnseitigen Basis (13a) zylindrisch und im Bereich des Gasentladungsraums (14) kegelförmig ausgebildet ist.

22. Vorrichtung gemäß einem der vorhergehenden Ansprüche,
**dadurch gekennzeichnet,**
**dass** die Gasentladungskammer (12) mittels einer Presspassung in den Hohlleiter (11) eingepasst ist.

23. Vorrichtung gemäß einem der vorhergehenden Ansprüche,
**dadurch gekennzeichnet,**
**dass** am Hohlleiter (11) eine Kühlung (20) vorgesehen ist, die die Gasentladungskammer (12) großflächig ummantelt.

24. Vorrichtung gemäß einem der vorhergehenden Ansprüche,
**dadurch gekennzeichnet,**
**dass** der Koppelstift (18a) an seinem Ende einen Knotenpunkt aufweist, der direkt anliegend an das Dielektrikum (13) angeordnet ist.

25. Vorrichtung gemäß einem der vorhergehenden Ansprüche,
**dadurch gekennzeichnet,**
**dass** die elektromagnetische Welle in die stirnseitige Basis (13a) mittels einer Hohlleiterzuführung (25) einkoppelbar ist.

26. Verfahren zur Erzeugung angeregter und/oder ionisierter Teilchen in einem Plasma aus einem Prozessgas, bei dem eine elektromagnetische Welle erzeugt und in ein Dielektrikum (13) einer Gasentladungskammer (12) eingekoppelt wird, wobei im Dielektrikum (13) ein Gasentladungsraum (14) ausgebildet ist, der einen Gaseinlass (15) und einen Gasauslass (16) zum Zu- bzw. Abführen von Prozessgas aufweist, und wobei die Gasentladungskammer (12) innerhalb eines Hohlleiters (11) angeordnet ist;
**dadurch gekennzeichnet,**
**dass** die elektromagnetische Welle mittels eines Koaxialleiters (18) in die Dielektrikum (13) eingekoppelt wird; und dass der Koaxialleiter (18) zumindest teilweise im Dielektrikum (13) eingebettet angeordnet ist und an seinem Ende einen Koppelstift (18a) oder eine Koppelspule (18b) aufweist, der/die im Dielektrikum (13) eingebettet angeordnet ist, und
**dass** die elektromagnetische Welle in eine stirnseitige Basis (13a) des Dielektrikums (13) mittels des Koppelstifts (18a) oder der Koppelspule (18b) des Koaxialleiters (18) eingekoppelt wird, wobei der Gasentladungsraum (14) zwischen der stirnseitigen Basis (13a) und dem Gasauslass (16) angeordnet ist.

27. Verfahren gemäß Anspruch 26,
**dadurch gekennzeichnet,**
**dass** die Gasentladungskammer (12) mit dem Gasentladungsraum (14) und mit dem Dielektrikum (13) Querschnittsverjüngung (21) und/oder Vorsprung (22) und/oder Schulter (24) aufweist, so dass durch geeignete Ausgestaltung des Dielektrikums (13) die Energie der in der stirnseitigen Basis (13a) in die Gasentladungskammer (12) eingekoppelten elektromagnetischen Welle bis zum Erreichen des Gasauslasses (16) verbraucht wird.

## Claims

1. A device for generating excited and/or ionized particles in a plasma from a process gas, comprising:
a generator (19) for generating an electromagnetic wave;
a waveguide (11); and
a gas discharge chamber (12) with a gas discharge space (14) in which the excited and/or
ionized particles are formed, and with a dielectric (13) in which the gas discharge space (14) is formed, the gas discharge chamber (12) being arranged inside the waveguide (11),
the dielectric (13) forming an end base (13a) from which side walls (13b) extend so as to form the gas discharge space (14), and
the electromagnetic wave being able to be coupled into the end base (13a),
**characterized in that**
the device comprises a coaxial conductor (18), and that the coaxial conductor (18) is arranged so it is at least partially embedded in the dielectric (13) and at its end comprises a coupling pin (18a) or a coupling coil (18b) which is arranged so it is embedded in the dielectric (13), and that the electromagnetic wave can be coupled into the end base (13a) by means of the coupling pin (18a) or the coupling coil (18b) of the coaxial conductor (18).

2. The device according to claim 1,
**characterized in that**
the gas discharge chamber (12) essentially fills the waveguide (11).

3. The device according to claim 1 or 2, with a gas inlet (15) and a gas outlet (16) for supplying or removing process gas into or from the gas discharge space (14),
**characterized in that**
the gas outlet (16) is provided at the end of the gas discharge space (14) opposing the end base (13a).

4. The device according to claim 3,
**characterized in that**
the gas inlet (15) is provided at the end of the gas discharge space (14) facing the end base (13a).

5. The device according to any one of the preceding claims,
**characterized in that**
the gas discharge chamber (12) is formed symmetrically with respect to the longitudinal axis of the waveguide (11).

6. The device according to any one of the preceding claims,
**characterized in that**
the end base (13a) is formed as a cylindrical or hemispherical body.

7. The device according to any one of the preceding claims,
**characterized in that**
the side walls (13b) of the gas discharge chamber (12) comprise at least one, in particular circumferential, cross-sectional taper (21).

8. The device according to claim 7, with a gas inlet (15) and a gas outlet (16) for supplying or removing process gas into or from the gas discharge space (14),
**characterized in that**
the at least one cross-sectional taper (21) is provided in the region of the gas outlet (16).

9. The device according to claim 7 or 8, with a gas inlet (15) and a gas outlet (16) for supplying or removing process gas into or from the gas discharge space (14),
**characterized in that**
a plurality of cross-sectional tapers (21) is provided, the size of the tapers (21) increasing in the direction of the gas outlet (16).

10. The device according to any one of claims 7 to 9,
**characterized in that**
the at least one cross-sectional taper (21) is formed as a circumferential annular groove.

11. The device according to any one of the preceding claims, with a gas inlet (15) and a gas outlet (16) for supplying or removing process gas into or from the gas discharge space (14),
**characterized in that**
the side walls (13b) of the gas discharge chamber (12) are formed in such a way that their cross-section continually tapers in the direction of the gas outlet (16).

12. The device according to any one of the preceding claims,
**characterized in that**
the side walls (13b) of the gas discharge chamber (12) comprise at least one, in particular circumferential, projection (22) which protrudes from the side of the side walls (13b) facing the waveguide (11) and the cross-section perimeter of which corresponds to half the wavelength of the electromagnetic wave.

13. The device according to claim 12, comprising a gas inlet (15) and a gas outlet (16) for supplying or removing process gas into or from the gas discharge space (14),
**characterized in that**
the at least one projection (22) is provided in the region of the gas outlet (16).

14. The device according to claim 12 or 13,
**characterized in that**
the at least one projection (22) is formed as a circumferential bead.

15. The device according to any one of the preceding claims,
**characterized in that**
at the side of the side walls (13b) facing the gas discharge space (14) at least one, in particular circumferential, shoulder (24) is provided, the length (24a) of which corresponds to a quarter of the wavelength of the electromagnetic wave.

16. The device according to claim 15, with a gas inlet (15) and a gas outlet (16) for supplying or removing process gas into or from the gas discharge space (14),
**characterized in that**
the gas outlet (16) is provided at the end of the gas discharge space (14) opposing the end base (13a), and
a plurality of circumferential shoulders (24) are arranged in a stepped manner one behind the other such that the gas discharge space (14) widens in the gas outlet direction.

17. The device according to any one of the preceding claims,
**characterized in that**
the waveguide (11) is formed essentially cuboidal, cylindrical or conical.

18. The device according to claim 17,
**characterized in that**
the waveguide (11) is formed cuboidal, the width of the waveguide (11) being greater than half the wavelength of the electromagnetic wave.

19. The device according to claim 17,
**characterized in that**
the waveguide (11) is formed as a circular cylinder, the diameter of the cylinder being greater than the cut-off wavelength of the electromagnetic wave.

20. The device according to any one of the preceding claims,
**characterized in that**
the waveguide (11) is differently shaped in certain sections.

21. The device according to claim 20,
**characterized in that**
the waveguide (11) is shaped cylindrically in the region of the end base (13a) and conically in the region of the gas discharge space (14).

22. The device according to any one of the preceding claims,
**characterized in that**
the gas discharge chamber (12) is fitted in the waveguide (11) by means of press fitting.

23. The device according to any one of the preceding claims,
**characterized in that**
a cooling system (20) which envelops the gas discharge chamber (12) over a large area is provided on the waveguide (11).

24. The device according to any one of the preceding claims,
**characterized in that**
at its end the coupling pin (18a) comprises a junction which is arranged directly adjacent to the dielectric (13).

25. The device according to any one of the preceding claims,
**characterized in that**
the electromagnetic wave can be coupled into the end base (13a) by means of a waveguide supply line (25).

26. A method for generating excited and/or ionized particles in a plasma from a process gas, in which an electromagnetic wave is generated and is coupled into a dielectric (13) of a gas discharge chamber (12), there being formed in the dielectric (13) a gas discharge space (14) which comprises a gas inlet (15) and a gas outlet (16) for supplying or removing process gas, and the gas discharge chamber (12) being arranged inside a waveguide (11),
**characterized in that**
the electromagnetic wave is coupled into the dielectric (13) by means of a coaxial conductor (18), and
the coaxial conductor (18) is arranged so it is at least partially embedded in the dielectric (13) and at its end comprises a coupling pin (18a) or a coupling coil (18b) which is arranged so it is embedded in the dielectric (13), and
the electromagnetic wave is coupled into an end base (13a) of the dielectric (13) by means of the coupling pin (18a) or the coupling coil (18b) of the coaxial conductor (18), the gas discharge space (14) being arranged between the end base (13a) and the gas outlet (16).

27. The method according to claim 26,
**characterized in that**
the gas discharge chamber (12) with the gas discharge space (14) and with the dielectric (13) comprises a cross-sectional taper (21) and/or projection (22) and/or shoulder (24) such that, as a result of suitable configuration of the dielectric (13), the energy of the electromagnetic wave coupled into the gas discharge chamber (12) in the end base (13a) is consumed up until the gas outlet (16) is reached.

## Revendications

1. Dispositif de production de particules excitées et/ou ionisées dans un plasma à partir d'un gaz de traitement, comprenant :
un générateur (19) pour produire une onde électromagnétique ;
un guide d'ondes (11) ; et
une chambre (12) de décharge du gaz avec un espace (14) de décharge du gaz, dans lequel les particules excitées et/ou ionisées sont formées, et avec un diélectrique (13) dans lequel est formé l'espace (14) de décharge du gaz, la chambre (12) de décharge du gaz étant disposée à l'intérieur du guide d'ondes (11),
le diélectrique (13) formant une base d'extrémité (13a) d'où partent des parois latérales (13b) pour former l'espace (14) de décharge du gaz, et
l'onde électromagnétique étant apte à être couplée à la base d'extrémité (1 3a),
**caractérisé en ce que**
le dispositif comprend un conducteur axial (18), et **en ce que** le conducteur axial (18) est disposé de façon qu'il soit au moins partiellement noyé dans le diélectrique (13) et comprend à son extrémité une broche de couplage (18a) ou un enroulement de couplage (18b) qui est disposé(e) de façon qu'elle/il soit noyé dans le diélectrique (13), et **en ce que** l'onde électromagnétique peut être couplée à la base d'extrémité (13a) au moyen de la broche de couplage (18a) ou de l'enroulement de couplage (18b) du conducteur coaxial (18).

2. Dispositif selon la revendication 1,
**caractérisé en ce que**
la chambre (12) de décharge du gaz remplit sensiblement le guide d'ondes (11).

3. Dispositif selon la revendication 1 ou 2, avec une entrée (15) pour le gaz et une sortie (16) pour le gaz, pour amener ou faire sortir du gaz de traitement dans ou hors de l'espace (14) de décharge du gaz
**caractérisé en ce que**
la sortie (16) pour le gaz est prévue à l'extrémité de l'espace (14) de décharge du gaz opposée à la base d'extrémité (13a).

4. Dispositif selon la revendication 3,
**caractérisé en ce que**
l'entrée (15) pour le gaz est prévue à l'extrémité de l'espace (14) de décharge du gaz située face à la base d'extrémité (13a).

5. Dispositif selon l'une quelconque des revendications précédentes,
**caractérisé en ce que**
la chambre (12) de décharge du gaz est conformée de manière symétrique par rapport à l'axe longitudinal du guide d'ondes (11).

6. Dispositif selon l'une quelconque des revendications précédentes,
**caractérisé en ce que**
la base d'extrémité (13a) est conformée en corps cylindrique ou hémisphérique.

7. Dispositif selon l'une quelconque des revendications précédentes,
**caractérisé en ce que**
les parois latérales (13b) de la chambre (12) de décharge du gaz présentent au moins une diminution (21) en section transversale, en particulier circonférentielle.

8. Dispositif selon la revendication 7, avec une entrée (15) pour le gaz et une sortie (16) pour le gaz pour amener ou faire sortir du gaz de traitement dans ou hors de l'espace (14) de décharge du gaz,
**caractérisé en ce que**
ladite au moins une diminution (21) en section transversale se trouve dans la zone de la sortie (16) pour le gaz.

9. Dispositif selon la revendication 7 ou 8, avec une entrée (15) pour le gaz et une sortie (16) pour le gaz pour amener ou faire sortir du gaz de traitement dans ou hors de l'espace (14) de décharge du gaz,
**caractérisé en ce que**
une pluralité de diminutions (21) en section transversales sont prévues, la taille des diminutions (21) augmentant en direction de la sortie (6) pour le gaz.

10. Dispositif selon l'une quelconque des revendications 7 à 9,
**caractérisé en ce que**
ladite au moins une diminution (21) en section transversale est conformée en rainure circonférentielle annulaire.

11. Dispositif selon l'une quelconque des revendications précédentes, avec une entrée (15) pour le gaz et une sortie (16) pour le gaz pour amener ou faire sortir du gaz de traitement dans ou hors de l'espace (14) de décharge du gaz,
**caractérisé en ce que**
les parois latérales (13b) de la chambre (12) de décharge du gaz sont conformées de telle manière que leur section transversale diminue de manière continue en direction de la sortie (16) pour le gaz.

12. Dispositif selon l'une quelconque des revendications précédentes,
**caractérisé en ce que**
les parois latérales (13b) de la chambre (12) de décharge du gaz comprennent au moins une saillie (22), en particulier circonférentielle, qui déborde de la face des parois latérales (13b) faisant face au guide d'ondes (11) et dont le périmètre en section transversale correspond à la moitié de la longueur d'onde de l'onde électromagnétique.

13. Dispositif selon la revendication 12, comprenant une entrée (15) pour le gaz et une sortie (16) pour le gaz pour amener ou faire sortir du gaz de traitement dans ou hors de l'espace (14) de décharge du gaz,
**caractérisé en ce que**
ladite au moins une saillie (22) est prévue dans la zone de la sortie (16) pour le gaz.

14. Dispositif selon la revendication 12 ou 13,
**caractérisé en ce que**
ladite au moins une saillie (22) est conformée en bourrelet circonférentiel.

15. Dispositif selon l'une quelconque des revendications précédentes,
**caractérisé en ce que**
sur la face des parois latérales (13b) faisant face à l'espace (14) de décharge du gaz, se trouve au moins un épaulement (24), en particulier circonférentiel, dont la longueur (24a) correspond à un quart de la longueur d'onde de l'onde électromagnétique.

16. Dispositif selon la revendication 15, avec une entrée (15) pour le gaz et une sortie (16) pour le gaz pour amener ou faire sortir du gaz de traitement dans ou hors de l'espace (14) de décharge du gaz,
**caractérisé en ce que**
la sortie (16) pour le gaz est prévue à l'extrémité de l'espace (14) de décharge du gaz opposée à la base d'extrémité (13a), et
une pluralité d'épaulements circonférentiels (24) sont disposés en gradins l'un derrière l'autre de telle sorte que l'espace (14) de décharge du gaz s'élargisse en direction de la sortie pour le gaz.

17. Dispositif selon l'une quelconque des revendications précédentes,
**caractérisé en ce que**
le guide d'ondes (11) est conformé sensiblement parallélépipédique, cylindrique ou conique.

18. Dispositif selon la revendication 17,
**caractérisé en ce que**
le guide d'ondes (11) est conformé parallélépipédique, la largeur du guide d'ondes (11) étant supérieure à la moitié de la longueur d'ondes de l'onde électromagnétique.

19. Dispositif selon la revendication 17,
**caractérisé en ce que**
le guide d'ondes (11) prend la forme d'un cylindre circulaire, le diamètre du cylindre étant supérieur à la longueur d'ondes critique de l'onde électromagnétique.

20. Dispositif selon l'une quelconque des revendications précédentes,
**caractérisé en ce que**
le guide d'ondes est conformé de manière différente dans certaines sections.

21. Dispositif selon la revendication 20,
**caractérisé en ce que**
le guide d'ondes est conformé cylindrique dans la zone de la base d'extrémité (13a) et conique dans la zone de l'espace (14) de décharge du gaz.

22. Dispositif selon l'une quelconque des revendications précédentes,
**caractérisé en ce que**
la chambre (12) de décharge du gaz est mise en place dans le guide d'ondes (11) par insertion en force.

23. Dispositif selon l'une quelconque des revendications précédentes,
**caractérisé en ce que**
un système de refroidissement (20) qui enveloppe la chambre (12) de décharge du gaz sur une large zone est prévu sur le guide d'ondes (11).

24. Dispositif selon l'une quelconque des revendications précédentes,
**caractérisé en ce que**
à son extrémité, la broche de couplage (18a) comprend une jonction qui est placée directement adjacente au diélectrique (13).

25. Dispositif selon l'une quelconque des revendications précédentes,
**caractérisé en ce que**
l'onde électromagnétique peut être couplée à la base d'extrémité (13a) au moyen d'une ligne (25) d'alimentation du guide d'ondes.

26. Procédé de production de particules excitées et/ou ionisées dans un plasma à partir d'un gaz de traitement, dans lequel une onde électromagnétique est formée et est couplée à un diélectrique (13) d'une chambre (12) de décharge de gaz, dans le diélectrique (13) étant formé un espace (14) de décharge de gaz qui comprend une entrée (15) pour le gaz et une sortie (16) pour le gaz, pour amener ou faire sortir du gaz de traitement, et la chambre (12) de décharge de gaz étant située à l'intérieur d'un guide d'ondes (11),
**caractérisé en ce que**
l'onde électromagnétique est couplée au diélectrique (13) au moyen d'un conducteur coaxial (18), et
le conducteur coaxial (18) est agencé de telle sorte qu'il soit au moins partiellement noyé dans le diélectrique (13) et comprend à son extrémité une broche de couplage (18a) ou un enroulement de couplage (18b) qui est disposé(e) de façon qu'elle/il soit noyé dans le diélectrique (13), et
l'onde électromagnétique est couplée à une base d'extrémité (13a) du diélectrique (13) au moyen de la broche de couplage (18a) ou de l'enroulement de couplage (18b) du conducteur coaxial (18), l'espace (14) de décharge du gaz étant situé entre la base d'extrémité (1 3a) et la sortie (16) pour le gaz.

27. Procédé selon la revendication 26,
**caractérisé en ce que**
la chambre (12) de décharge du gaz avec l'espace (14) de décharge du gaz et avec le diélectrique (13) comprend une diminution (21) en section transversale, et/ou une saille (22) et/ou un épaulement (24) de telle sorte que, en résultat d'une configuration adaptée du diélectrique (13), l'énergie de l'onde électromagnétique couplée à la chambre (12) de décharge du gaz dans la base d'extrémité (13a) soit consommée jusqu'à ce que la sortie (16) pour le gaz soit atteinte.
